# EUROPEAN PATENT APPLICATION

(11) **EP 4 517 848 A1**
(43) Date of publication of application: **05.03.2025**
(21) Application number: 23826957.5
(22) Date of filing: 05.06.2023
(51) Int. Cl.: H01L 33/62

(54) **LIGHT-EMITTING DEVICE**

(30) Priority: 22.06.2022 JP 2022100686
(71) Applicant: Stanley Electric Co. Ltd., Tokyo 153-8636 (JP)
(72) Inventor: SHIMODA, Yoichi, Tokyo 153-8636 (JP); KAMBARA, Daizo, Tokyo 153-8636 (JP); SHIGEEDA, Yuji, Tokyo 153-8636 (JP); ICHIKAWA, Koji, Tokyo 153-8636 (JP); ISHIKO, Hiroyuki, Tokyo 153-8636 (JP)
(74) Representative: Carstens, Dirk Wilhelm
(86) International application number: PCT/JP2023/020776
(87) International publication number: WO 2023/248770

(57) **Abstract**

The present invention provides a semiconductor light-emitting device that includes: a plurality of plate-shaped lead electrodes; a resin frame body which is provided to enclose an entire outer periphery of the plurality of lead electrodes while burying a gap between the plurality of lead electrodes, and has an opening that exposes the plurality of lead electrodes; and a semiconductor light-emitting element mounted on the plurality of lead electrodes exposed through the opening. A corner and/or an outer side surface of the frame body has a recess in which an end portion of the lead electrode is exposed therein at a position set back from the outer side surface of the frame body.

## Description

### Technical Field

The present invention relates to a light-emitting device, and more particularly to a light-emitting device having a semiconductor light-emitting element such as a light-emitting diode (LED) mounted on a lead frame.

### Background Art

There has conventionally been known a light-emitting device formed by providing a resin body on a lead frame by insert molding and then cutting the resin body and the lead frame with a dicer.

For example, Patent Literature 1 discloses a method for forming a light-emitting device by forming a resin molded body on a lead frame provided with notches, and cutting the resin molded body and the lead frame along the notches.

Further, Patent Literature 2 discloses a surface-mounted light-emitting device having a first resin molded body composed of a light-emitting element and a first and a second leads, which are integrally molded, and a second resin molded body containing a phosphor coating the light-emitting element.

### Citation List

### Patent Literatures

Patent Literature 1: Japanese Patent Application Laid-Open No. 2010-62272
Patent Literature 2: Japanese Patent Application Laid-Open No. 2006-156704

### Summary of Invention

### Technical Problem

However, there has been a problem in that cutting integrally molded resin and lead frame causes peeling between the resin and the lead frame, a decrease in die shear strength, broken wires, and the like.

The present invention has been made in view of the problem described above, and an object of the invention is to provide a light-emitting device that prevents peeling between a resin and a lead frame, exhibits high die shear strength, and is less susceptible to defects such as wire breakage.

### Solution to Problem

A light-emitting device according to a first embodiment of the present invention is a semiconductor light-emitting device including:
a plurality of plate-shaped lead electrodes;
a resin frame body which is provided to enclose an entire outer periphery of the plurality of lead electrodes while burying a gap between the plurality of lead electrodes, and has an opening that exposes the plurality of lead electrodes; and
a semiconductor light-emitting element mounted on the plurality of lead electrodes exposed through the opening,
wherein a corner and/or an outer side surface of the frame body has a recess in which an end portion of the lead electrode is exposed at a position set back from the outer side surface of the frame body.

### Brief Description of Drawings

FIG. 1A is a conceptual diagram illustrating an essential section of a light-emitting device 10 according to a first embodiment of the present invention, and is a perspective view thereof observed from above.
FIG. 1B is a conceptual diagram illustrating the essential section of the light-emitting device 10 according to the first embodiment of the present invention, and is a perspective view thereof observed from below.
FIG. 2A is a diagram illustrating an upper surface of the light-emitting device 10.
FIG. 2B is a sectional view along line A-A illustrated in FIG. 2A.
FIG. 2C is a side view observed from direction B illustrated in FIG. 2A.
FIG. 3 is a diagram illustrating the upper surface of the light-emitting device 10 before being filled with a coating member 35.
FIG. 4 is a diagram illustrating the back surface (the surface to be mounted on a circuit board) of the light-emitting device 10.
FIG. 5 is a partial enlarged perspective view of a recess 23 in an enlarged view.
FIG. 6 is a partial enlarged perspective view illustrating a solder joint in an enlarged view when the light-emitting device 10 is mounted on wiring 41 of a circuit board 40 by using solder 45.
FIG. 7 is a partial enlarged perspective view illustrating, in an enlarged view, the recess 23 having an arc shape (fan-like shape), which is a modified example of the present embodiment.
FIG. 8 is a flowchart illustrating a manufacturing method of the light-emitting device 10.
FIG. 9A is a top view illustrating manufacturing steps S1 and S2 of the light-emitting device 10.
FIG. 9B is a top view illustrating manufacturing step S3 of the light-emitting device 10.
FIG. 9C is a top view illustrating manufacturing step S4 of the light-emitting device 10.
FIG. 9D is a top view illustrating manufacturing step S5 of the light-emitting device 10.
FIG. 9E is a top view illustrating manufacturing steps S6 and S7 of the light-emitting device 10.
FIG. 9F is a top view illustrating manufacturing step S8 of the light-emitting device 10.
FIG. 9G is a top view illustrating manufacturing step S9 of the light-emitting device 10.
FIG. 10A is a schematic top view illustrating an intersectional part X of a lead frame 12 in an enlarged view.
FIG. 10B is a sectional view illustrating the sections of the intersectional part X in step S4 and step S5.
FIG. 10C is a diagram illustrating a removal region RC of the lead frame 12 in the case where the recess 23 having an arc shape is formed.

### Description of Embodiments

The following will describe preferred embodiments of the present invention, which may be modified or combined as appropriate. In the following description and accompanying drawings, substantially the same or equivalent components will be assigned the same reference numerals.

### [First Embodiment]

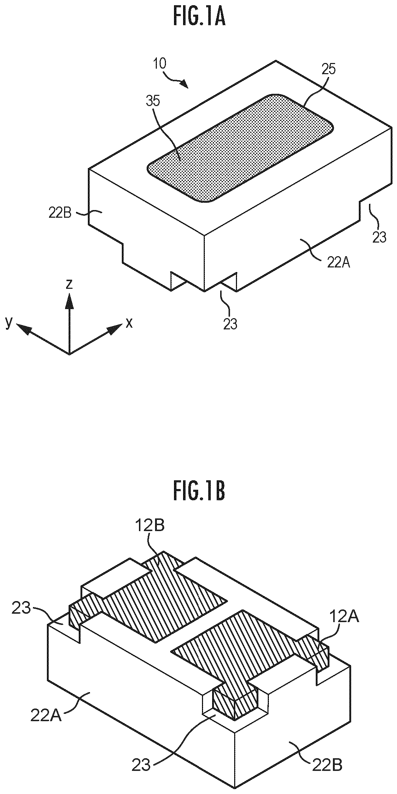

FIG. 1A and FIG. 1B are conceptual diagrams illustrating an essential section of a light-emitting device 10 according to a first embodiment of the present invention, and are perspective views of the essential section observed from the upper surface side and the lower surface side, respectively. The light-emitting device 10 has a plurality of lead electrodes (hereinafter also referred to simply as "the leads") and a resin frame body 22. The following will describe a case where the light-emitting device 10 has two leads 12A and 12B; however, the light-emitting device 10 may have three or more leads.

As illustrated in FIG. 1A, the resin frame body 22 has an opening 25 in which a light-emitting element is installed, and the opening 25 is filled with the coating member 35.

As illustrated in FIG. 1B, the four corners on the back surface of the light-emitting device 10 have recesses 23 where the corners of the leads 12A and 12B are exposed inside.

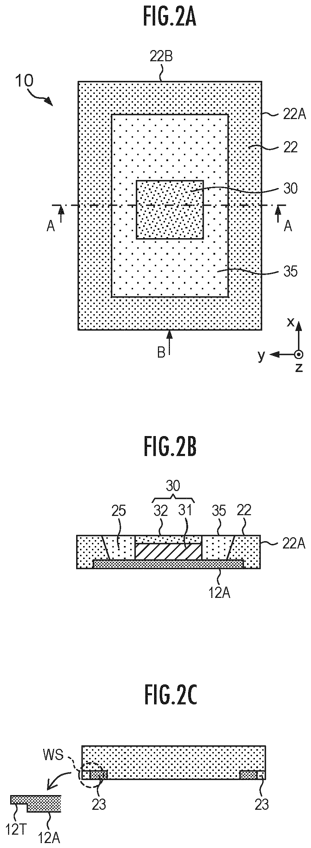

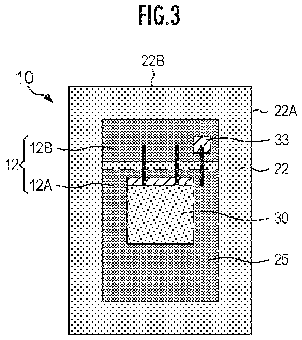

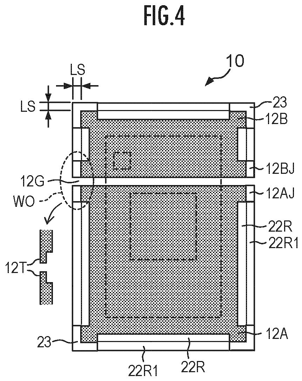

FIG. 2A is a diagram illustrating the upper surface of the light-emitting device 10, and FIG. 2B is a sectional view taken along line A-A illustrated in FIG. 2A. Further, FIG. 2C is a side view observed from direction B illustrated in FIG. 2A. Further, FIG. 3 is a diagram illustrating the upper surface of the light-emitting device 10 before being filled with the coating member 35, and FIG. 4 is a diagram illustrating the back surface (the surface to be mounted on a circuit board) of the light-emitting device 10.

### (1) Resin frame body and leads

The light-emitting device 10 has the lead 12A (first electrode) and the lead 12B (second electrode), which have plate shapes. The core material of the lead 12A and the lead 12B is made of copper (Cu), which is a metal that has good etching properties (corrosive properties), and the surface thereof is plated with nickel/gold (Ni/Au), which is a corrosion-resistant metal.

Aluminum (Al), which is a corrosive metal, or an iron alloy such as iron-nickel-cobalt (Fe-Ni-Co) can be used as the core material of the lead 12A and the lead 12B.

Further, a corrosion-resistant metal such as platinum (Pt), palladium (Pd), or rhodium (Rh) can be used for the surfaces of the lead 12A and the lead 12B.

In the present specification, a lead pair 12 consisting of the leads 12A and 12B (hereinafter also referred to as a lead frame 12 of the light-emitting device 10) is formed on substantially the same surface and separated from each other by a gap (slit) 12G between the leads 12A and 12B. In the following, the lead 12A and the lead 12B will be referred to simply as the leads when there is no particular distinction therebetween.

The resin frame body 22 is insert-molded around the leads 12A and 12B, and the resin frame body 22 is provided so as to enclose the entire outer periphery of the leads while filling the gap between the leads thereby to form a resin package. In other words, the leads are not exposed on an outer side surface of the resin frame body 22 and on a surface substantially the same as the outer side surface.

The resin frame body 22 is formed by, for example, adding titanium oxide particles to a silicone resin, an epoxy resin, or an acrylic resin (white resin). Alternatively, the resin frame body 22 may be formed by adding carbon black to a silicone resin, an epoxy resin, or an acrylic resin (black resin).

As illustrated in FIG. 1A and FIG. 1B, the resin frame body 22 has a rectangular shape (rectangular columnar shape) and has two outer side surfaces 22A parallel to each other and two outer side surfaces 22B perpendicular to the outer side surfaces 22A. In addition, the four corners of the back surface of the resin frame body 22 have the recesses 23 in which the corners of the leads 12A and 12B are exposed inside.

As illustrated in FIG. 2C, thinner portions 12T are provided at outer edge portions WS of the leads 12A and 12B excluding the corners. In addition, as illustrated in FIG. 4, thinner portions 12T are provided at edge portions WO where the leads 12A and 12B face each other. The thinner portions 12T cover the edges of the leads 12A and 12B by the resin of the resin frame body 22, thus preventing the leads from peeling off from the resin frame body 22 during dicing or the like.

The thinner portions 12T are formed by so-called half etching to a depth of, for example, approximately 50% relative to the thickness of the leads 12A and 12B.

### (2) Recesses of the resin frame body

The light-emitting device 10 is mounted by placing the back surface of the light-emitting device 10 (i.e., the back surface of the resin frame body 22) on a circuit board or the like, and attaching by using solder or the like. As illustrated in FIG. 1B and FIG. 4, the recesses 23 are provided at the four corners of the back surface (mounting surface) of the resin frame body 22.

Further, as described above, the resin frame body 22 is provided so as to enclose the entire outer peripheries of the leads, burying the gap between the leads. The end portions of the leads are exposed in the recesses 23.

### (Rectangular recesses)

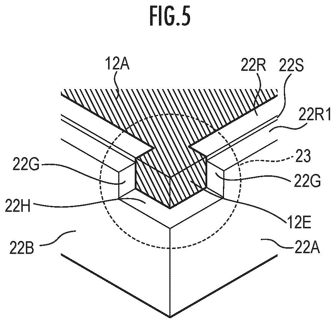

FIG. 5 is a partial enlarged perspective view of the recess 23 in an enlarged view. In the recess 23, the resin frame body 22 is recessed from the outer side surfaces 22A and 22B, and the rectangular corner of the lead 12A is exposed in the recess 23. The recess 23 in which the corner of the lead 12A is exposed will be described. The same applies to the recess 23 in which the corner of the lead 12B is exposed.

More specifically, in the recess 23, an end surface 12E of the corner of the lead 12A is located in a position recessed inward from the outer side surfaces 22A and 22B of the resin frame body 22. This means that, in the recess 23, the resin frame body 22 has a rectangular (L-shaped) bottom surface 22H, and the end surface 12E of the lead 12A is located in a position recessed inward from the outer side surfaces 22A and 22B by a distance LS (FIG. 4).

Further, on both sides of the corner of the lead 12A, fillet guards 22G are formed as the partition walls of the resin frame body 22. A rectangular space for accommodating a solder fillet is defined in the recess 23 by the fillet guards 22G and the bottom surface 22H of the resin frame body 22. In other words, the recess 23 functions as a rectangular housing for accommodating the solder fillet.

As will be described later, if the bottom surface 22H is formed by etching the lead 12A, then the depths (heights) of the bottom surface 22H and the fillet guards 22G are substantially the same as the thickness of the lead 12A.

In the case where the recess 23 is formed by etching a core material 12C of the lead frame 12, and a milling process or the like for a lead frame surface layer (plating layer) is used in combination with the etching, an outer peripheral portion 22R1 of a back surface 22R of the resin frame body 22 is formed slightly lower than the back surface 22R by the process and has a step 22S with respect to the back surface 22R, as illustrated in FIG. 4 and FIG. 5.

In this case, even if there is a burr on the lower end of the outer side surfaces of the resin frame body 22 of the light-emitting device 10, the light-emitting device 10 can be mounted without being detached from the circuit board. Thus, it is possible to achieve mounting with high die shear strength and without impairing heat dissipation and reliability.

Further, when mounting the light-emitting device 10 on a wiring pattern of the same size as the light-emitting device 10, even if there are burrs on the peripheral edge of the wiring pattern, it is possible to prevent the light-emitting device 10 from tilting, thus preventing the optical axis from shifting.

The back surface 22R of the resin frame body 22 may be a flat surface without the step 22S. For example, the recess 23 may be formed by removing only the surface layer (plating layer) of the lead frame 12 by a micro milling cutter or the like such that the step 22S is not formed.

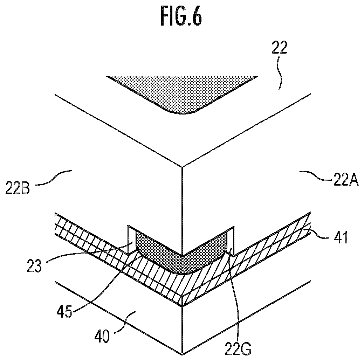

FIG. 6 is a partial enlarged perspective view illustrating a solder joint in an enlarged view when the light-emitting device 10 is mounted on the wiring (land) 41 of the circuit board 40 by using the solder 45.

The fillet of the solder 45 is formed in the recess 23, thus making it possible to maintain high die shear strength also in the case of mounting the light-emitting device 10 on the wiring that is approximately the same size therewith.

### (Arc-shaped recess)

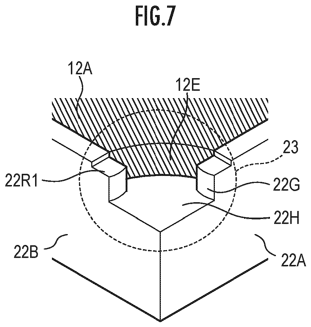

FIG. 7 is a partial enlarged perspective view illustrating, in an enlarged view, the recess 23, which is a modified example of the present embodiment. In the present modified example, the recess 23 having an arc shape (fan-like shape) is formed.

More specifically, in the recess 23, the bottom surface 22H of the resin frame body 22 has an arc shape (or a quadrant shape), and the end surface (side surface) 12E of the end portion of the lead 12A has a cylindrical side surface shape.

Further, the fillet guards 22G, which are the partition walls extending and protruding from the resin frame body 22, are formed on both sides of the end portion of the lead 12A. A quarter-cylindrical space for accommodating the solder fillet is defined in the recess 23 by the fillet guards 22G and the bottom surface 22H of the resin frame body 22. In other words, the arc-shaped recess 23 functions as a housing for accommodating the solder fillet. The above-described protruding fillet guards 22G hold a part of the solder fillet in a necking manner, thus making it possible to increase the die shear strength.

As with the case of the rectangular recess 23, the fillet of the solder 45 is formed in the recess 23, so that high die shear strength can be maintained even when mounting the light-emitting device 10 on wiring of approximately the same size as the light-emitting device 10.

The above has described the cases where the recesses 23 of the resin frame body 22 are rectangular and arc-shaped recesses, but the recesses 23 of other shapes may be formed as long as the recesses have the end surfaces of the leads exposed therein and have spaces for accommodating the solder fillets to be connected to the lead end surfaces.

In addition, the case has been described, as an example, where the recesses 23 are provided at the corners of the light-emitting device 10 (i.e., the resin frame body 22); however, the present invention is not limited thereto. For example, the recesses may be provided in the sides of the light-emitting device 10. More specifically, referring to FIG. 4, a joint 12AJ or 12BJ of the lead 12A or 12B that connects with an adjacent lead may be formed as the recess 23 having a rectangular shape (e.g., an I shape). Therefore, the recesses 23 may be provided at the corners and/or the sides of the light-emitting device 10.

### (3) Internal structure of the light-emitting device and light-emitting element

As illustrated in FIG. 3, the resin frame body 22 has the opening 25 (first opening), which is an inner region of the frame body, and the surfaces of the lead 12A and the lead 12B are partly exposed through the opening 25. A semiconductor light-emitting element (hereinafter referred to simply as the light-emitting element) 30 is installed in the opening 25.

The light-emitting element 30 in the present embodiment is composed of an LED (Light Emitting Diode) 31, which is a light source element, and a phosphor 32, which is an optical member provided on the light source element. However, the light source element may alternatively be a laser diode (LD) or the like. Further, the optical member is not limited to a phosphor. Further, the optical member may not be provided.

More specifically, for example, the lead 12A is an anode electrode, the lead 12B is a cathode electrode, a p-electrode of the LED 31 is connected to and placed on the lead 12A, and an n-electrode of the LED 31 is connected to the lead 12B by bonding wire.

Further, the plate-shaped phosphor 32 is provided on the LED 31. Alternatively, the light-emitting element 30 may have an optical member such as a translucent member provided on the LED 31. Although there is no particular limit to a phosphor, various types of phosphors such as YAG (yttrium aluminum garnet), LuAG (lutetium aluminum garnet), GYAG (gadolinium aluminum garnet), α, β sialon, SCASN, CASN, KFS can be appropriately used. In addition, when an optical member such as a translucent member is included, a nanoparticle light conversion member of a cadmium selenium (CdSn)-based, indium phosphide (InP)-based, or indium nitride (InN)-based member, or the like can be placed on the upper surface (light exit surface) of the LED 31. In particular, the nanoparticle light conversion member is preferably placed within a hundred and several tens of nm from the upper surface of the LED 31, because the light conversion efficiency is improved by quantum coupling.

Further, a protection element 33, which is a Zener diode, is mounted by bonding on the lead 12B exposed through the opening 25. The other electrode of the protection element 33 is connected to the lead 12A by bonding wire.

A varistor or the like can be used as the protection element 33. Further, a passive element such as a capacitor, a resistor, or a light receiving element may be provided.

In the opening 25 of the resin frame body 22, the space around the light-emitting element 30 is filled with the coating member 35, which is a sealing resin or a coating resin. In FIG. 3, the coating member 35 is not illustrated, since the drawing is for describing the internal structure. Further, the surface of the light-emitting element 30 (i.e., the surface of the phosphor 32) is exposed from the coating member 35.

As illustrated in FIG. 3, the resin frame body 22 has a rectangular shape when viewed from above, and has a rectangular columnar opening 25, which is an inner region of the frame body. The opening 25 is not limited to the rectangular columnar shape, and may alternatively have a cylindrical shape, a truncated cone shape, or other shape.

### (4) Manufacturing method for the light-emitting device

The following will describe in detail the manufacturing method for the light-emitting device 10 by referring to a flowchart and the accompanying drawings.

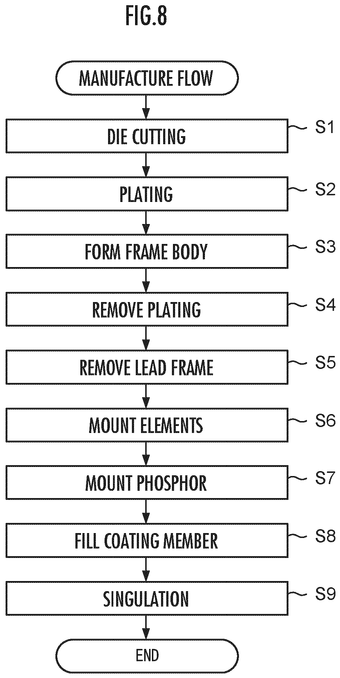

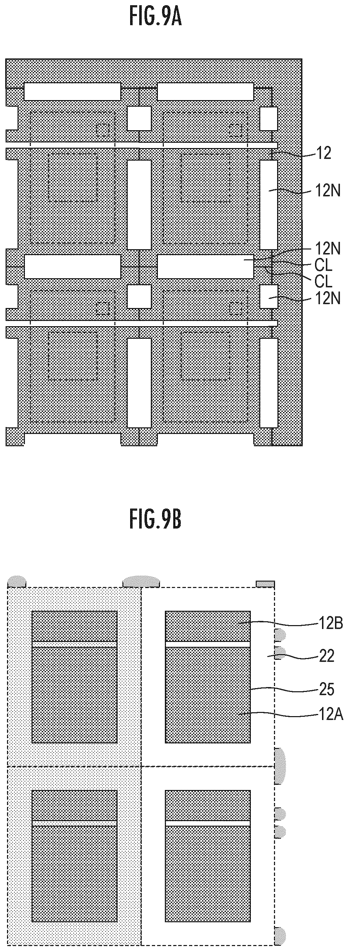

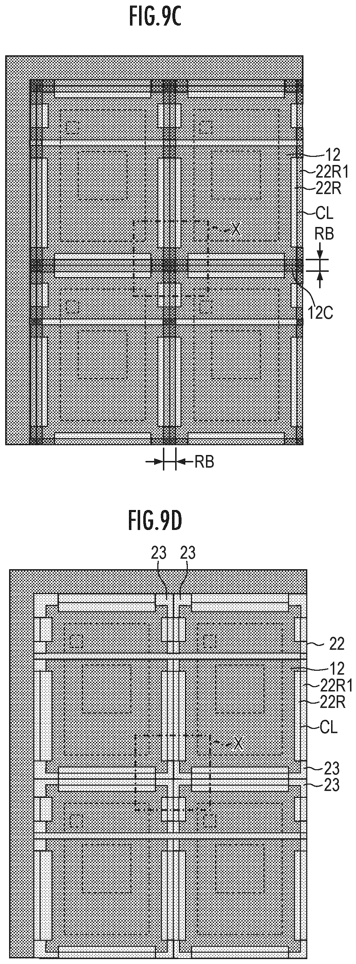

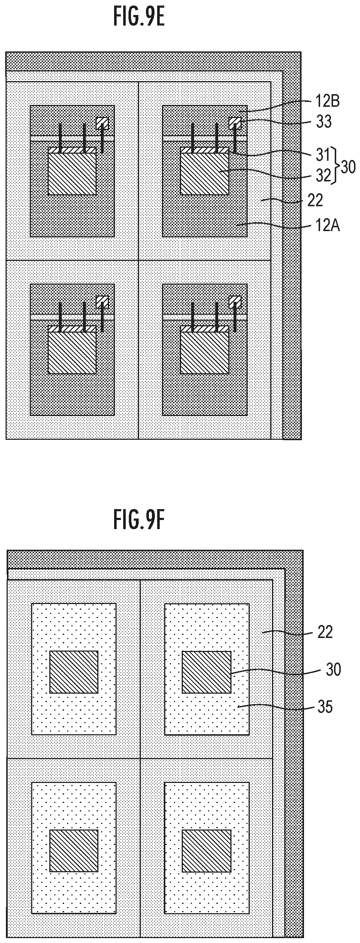

FIG. 8 is a flowchart illustrating the manufacturing method for the light-emitting device 10. Further, FIG. 9A to FIG. 9G are top views illustrating steps. FIG. 9A, FIG. 9B, and FIG. 9E to FIG. 9G are top views, FIG. 9C and FIG. 9D being back surface views. In each drawing, for the purpose of clarity, cutting lines CL, along which the devices are divided, are indicated by solid lines, and element mounting portions are indicated by dotted lines.

### (S1) Die cutting step

A prepared copper (Cu) plate that will become the lead frame 12 is punched by a die to form punched portions 12N (FIG. 9A). Instead of punching, a resist mask may be formed and die-cut by etching. When forming the thinner portions 12T at the outer edge of the lead frame 12, a resist mask with openings in the portions that will become the thinner portions 12T is formed before forming the punched portions 12N, and the resist mask is etched to be thinner.

### (S2) Plating step

The upper surface of the lead frame 12 is plated with nickel (Ni) and gold (Au) in this order (Ni/Au plating) by electrolytic plating (FIG. 9A).

### (S3) Frame body forming step

Subsequently, the resin frame body 22 of thermosetting resin is formed on the lead frame 12 by insert molding (FIG. 9B). The resin frame body 22 has the opening 25, which is the inner region of the resin frame body 22, and the surfaces of the lead 12A and the lead 12B are partly exposed through the opening 25.

### (S4) Plating removal step

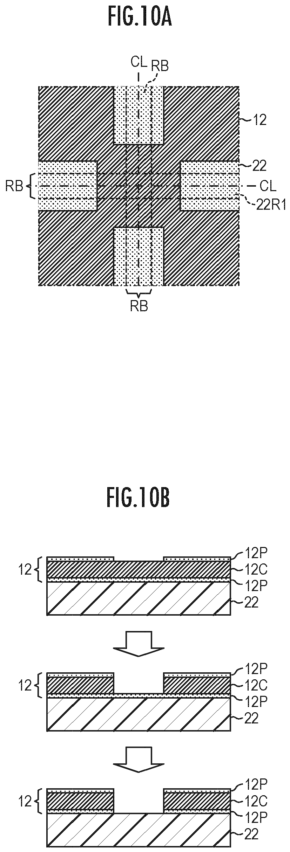

FIG. 10A is a schematic top view illustrating an intersectional part X of the cutting lines CL of the lead frame 12 (refer to FIG. 9C and FIG. 9D) in an enlarged view, and FIG. 10B is a sectional view illustrating the sections of the intersectional part X in step S4 and step S5.

First, a plating layer 12P on the surface of the lead frame 12 is removed by dicing (rectangular teeth) along the cutting lines CL at predetermined widths (plating removal portions RB) (FIG. 10B, top). The core material 12C (Cu) is exposed at the plating removal portions RB (FIG. 9C).

At this time, the outer peripheral portion 22R1 of the back surface 22R of the resin frame body 22 is also cut to form the step 22S, which is slightly lower than the back surface 22R (refer to FIG. 5).

The plating layer 12P may be removed by milling or the like instead of dicing.

### (S5) Lead frame removal step

Subsequently, the core material 12C (Cu) of the lead frame 12 of the plating removal portions is etched using an etching solution (FIG. 10B, middle).

Next, the plating layer 12P on the resin frame body 22 is removed by air blasting (FIG. 10B, bottom). Other removal methods include water jet blasting. The plating layer 12P on the resin frame body 22 can be left. In such a case, this step is skipped. The plating layer 12P that has been left functions as a solder attraction wall when the light-emitting device 10 is soldered to a circuit board.

The rectangular recess 23 (FIG. 5) is formed at a corner of the resin frame body 22 by etching the lead frame 12 at the intersectional part X (FIG. 9D).

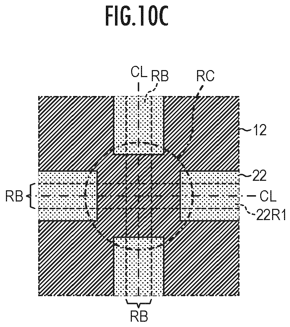

FIG. 10C illustrates a removal region RC of the lead frame 12 in the case where the recess 23 having the arc shape is formed. By removing the intersectional part X of the lead frame 12 in a circular shape, the recesses 23 having the end surfaces 12E, which have the shape of cylindrical side surfaces, can be formed at the four corners of the lead (FIG. 7).

### (S6) Element mounting step

Gold-tin (Au-Sn) solder paste is printed on the element mounting area. Then, the light-emitting element 30 and the protection element 33 are mounted on the solder.

Reflow (heating at 300°C) is performed to melt and solidify the gold-tin solder to mount the elements.

Gold wire is used to perform wire bonding of the light-emitting element 30 and the protection element 33 thereby to mount the elements (FIG. 9E).

### (S7) Phosphor mounting step

Silicone resin, which is a translucent adhesive, is applied to the light exit surface of the LED 31. Next, the phosphor 32 is mounted on the LED 31. Then, temporary curing is performed at 180°C to bond the phosphor 32 (FIG. 9E).

### (S8) Coating member filling step

Subsequently, the opening 25 of the resin frame body 22 is filled with a coating resin made of silicone resin containing titanium oxide particles, and the resin is cured by heating at 150°C for three hours to form the coating member 35 (FIG. 9F).

### (S9) Singulation step

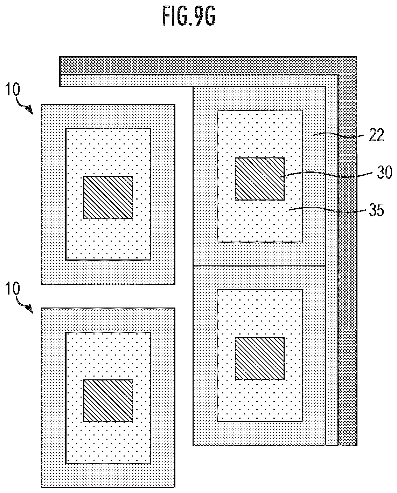

Lastly, the singulation is performed by cutting with a dicer into each device. The light-emitting device 10 is manufactured by the steps described above (FIG. 9G).

According to the present invention, in the lead frame removal step (S5), the lead frame 12 is cut by etching, and the lead frame 12 is not cut in the singulation step (S9).

If the lead frames are cut at the time of singulation into individual light-emitting devices, a resin frame body may peel off due to a cutting stress applied to the lead frame. According to the present invention, the lead frame 12 of a cut portion is removed in advance, so that there will be no peeling between the lead frame 12 and the resin frame body 22. Thus, it is possible to provide a light-emitting device that has high die shear strength and is less susceptible to wire breakage and the like.

As described in detail above, the present invention can provide a light-emitting device that prevents peeling between a frame body and a lead frame, exhibits high solder joint die shear strength, and is less susceptible to wire breakage and the like.

### Description of Reference Numerals

10: light-emitting device
12: lead frame
12A, 12B: lead
12E: end surface of lead
22: resin frame body
22A, 22B: outer side surface
22G: fillet guard
22H: bottom surface of resin frame body 22
22R: back surface of resin frame body 22
22R1: outer peripheral portion of back surface 22R
23: recess
30: light-emitting element
31: LED
32: phosphor
35: coating member
40: circuit board
45: solder
CL: cutting line
RB: plating removal portion

## Claims

1. A semiconductor light-emitting device comprising:
a plurality of plate-shaped lead electrodes;
a resin frame body which is provided to enclose an entire outer periphery of the plurality of lead electrodes while burying a gap between the plurality of lead electrodes, and has an opening that exposes the plurality of lead electrodes; and
a semiconductor light-emitting element mounted on the plurality of lead electrodes exposed through the opening,
wherein a corner and/or an outer side surface of the frame body has a recess in which an end portion of the lead electrode is exposed therein at a position set back from the outer side surface of the frame body.

2. The semiconductor light-emitting device according to Claim 1, wherein the end portion of the lead electrode exposed in the recess has a rectangular shape.

3. The semiconductor light-emitting device according to Claim 1, wherein the end portion of the lead electrode exposed in the recess has an arc shape.

4. The semiconductor light-emitting device according to Claim 1, wherein the recess has a height equivalent to a thickness of the lead electrode.

5. The semiconductor light-emitting device according to Claim 1, wherein a back surface of the resin frame body has an outer peripheral portion that is lower than the back surface of the resin frame body.

6. The semiconductor light-emitting device according to Claim 1, wherein a core material of the lead electrode is a corrosive metal, and a surface layer of the lead electrode is a corrosion-resistant metal.

7. The semiconductor light-emitting device according to Claim 6, wherein the core material of the lead electrode is a metal that contains any one or more of copper (Cu), aluminum (Al), and iron (Fe), and the surface layer of the lead electrode is a metal that contains any one or more of gold (Au), platinum (Pt), palladium (Pd), and rhodium (Rh).

8. The semiconductor light-emitting device according to any one of Claims 1 to 6, wherein the resin frame body has a partition wall that separates the end portion of the lead electrode, which is exposed in the recess, from an outer side surface of the resin frame body.

## Amended claims

### Amended claims under Art. 19.1 PCT

1. A semiconductor light-emitting device comprising:
a plurality of plate-shaped lead electrodes that have upper surfaces and back surfaces;
a resin frame body which is provided to enclose an entire outer periphery of the plurality of lead electrodes while burying a gap between the plurality of lead electrodes, and has an opening that exposes the plurality of lead electrodes; and
a semiconductor light-emitting element mounted on the upper surfaces of the plurality of lead electrodes exposed through the opening,
wherein a corner and/or an outer side surface of the resin frame body has a recess in which an end portion of the lead electrode which extends from the back surface to the upper surface is exposed therein at a position set back from the outer side surface of the resin frame body.

2. The semiconductor light-emitting device according to Claim 1, wherein the end portion of the lead electrode exposed in the recess has a rectangular shape.

3. The semiconductor light-emitting device according to Claim 1, wherein the end portion of the lead electrode exposed in the recess has an arc shape.

4. The semiconductor light-emitting device according to Claim 1, wherein the recess has a height equivalent to a thickness of the lead electrode.

5. The semiconductor light-emitting device according to Claim 1, wherein a back surface of the resin frame body has an outer peripheral portion formed to be thinner by providing a step on the back surface of the resin frame body, which is flush with the back surface of the lead electrode.

6. The semiconductor light-emitting device according to Claim 1, wherein a core material of the lead electrode is a corrosive metal, and a surface layer of the lead electrode is a corrosion-resistant metal.

7. The semiconductor light-emitting device according to Claim 6, wherein the core material of the lead electrode is a metal that contains any one or more of copper (Cu), aluminum (Al), and iron (Fe), and the surface layer of the lead electrode is a metal that contains any one or more of gold (Au), platinum (Pt), palladium (Pd), and rhodium (Rh).

8. The semiconductor light-emitting device according to any one of Claims 1 to 6, wherein the resin frame body has a partition wall that separates the end portion of the lead electrode, which is exposed in the recess, from an outer side surface of the resin frame body.

Statement under Art. 19.1 PCT
In Claim 1/Claims, the description "a plurality of plate-shaped lead electrodes that have upper surfaces and back surfaces" is based on the matters which are described in paragraphs "0010" to "0013" and paragraph "0023" in the specification at the time of filing, and which are illustrated in FIG. 1 to FIG. 3. In Claim 1/Claims, the description "a semiconductor light-emitting element mounted on the upper surfaces of the plurality of lead electrodes" is based on the matters illustrated in FIG. 2B and FIG. 3 at the time of filing. In Claim 1/Claims, the description "the frame body" is to correct an erroneous description. In Claim 1/Claims, the description "an end portion of the lead electrode which extends from the back surface to the upper surface is exposed therein at a position set back from the outer side surface of the resin frame body" is based on the matters illustrated in FIG. 1B, FIG. 2C and FIG. 5 to FIG. 7 at the time of filing.

In Claim 5/Claims, the description "a back surface of the resin frame body has an outer peripheral portion formed to be thinner by providing a step on the back surface of the resin frame body, which is flush with the back surface of the lead electrode" is based on the matters which are described in paragraph "0029" in the specification at the time of filing, and which are illustrated in FIG. 1B, FIG. 2B, FIG. 2C, FIG. 5, and FIG. 7.
